(19) Europäisches Patentamt
European Patent Office
Office européen des brevets

(11) **EP 1 906 527 A2**

(12) **EUROPÄISCHE PATENTANMELDUNG**

(43) Veröffentlichungstag:
**02.04.2008 Patentblatt 2008/14**

(51) Int Cl.:
***H03H 17/06*** *(2006.01)*

(21) Anmeldenummer: **07018285.2**

(22) Anmeldetag: **18.09.2007**

(84) Benannte Vertragsstaaten:
**AT BE BG CH CY CZ DE DK EE ES FI FR GB GR HU IE IS IT LI LT LU LV MC MT NL PL PT RO SE SI SK TR**
Benannte Erstreckungsstaaten:
**AL BA HR MK YU**

(30) Priorität: **26.09.2006 DE 102006045794**

(71) Anmelder: **Micronas GmbH**
**79108 Freiburg (DE)**

(72) Erfinder: **Petrov, Mihail**
**9500 Villach (AT)**

(74) Vertreter: **Patentanwälte**
**Westphal, Mussgnug & Partner**
**Am Riettor 5**
**78048 Villingen-Schwenningen (DE)**

(54) **Vorrichtung und Verfahren zum polyphasigen Resampling**

(57) Die Erfindung bezieht sich auf ein Verfahren bzw. eine Vorrichtung zum polyphasigen Resampling mit einem Koeffizienten-Generator (11) zum Bereitstellen einer Vielzahl von Koeffizienten (C0, C1, ..., C5) und einer Interpolationsanordnung zum Durchführen des Resamplings mittels der Koeffizienten (C0 - C5) auf Eingangsdaten (Din; Yin, Uin, Vin) zur Bereitstellung dem Resampling unterzogener Ausgangsdaten (Dout; Yout, Uout, Vout). Bevorzugt ist dabei, wenn der Koeffizienten-Generator (11) ausgebildet und/oder angesteuert ist zum Bereitstellen der Koeffizienten (C0 - C5) für das Resampling als linear interpolierte Koeffizienten. Vorteilhaft wird insbesondere, dass eine Vielzahl von zumindest zwei Daten-Interpolationsfiltern zum Interpolieren einer entsprechenden Anzahl von parallelen Eingangsdaten (Yin, Uin, Vin) bereitgestellt ist, wobei die Koeffizienten (C0 - C5) jedem der Daten-Interpolationsfilter angelegt werden.

Fig. 1

## Beschreibung

Die Erfindung bezieht sich auf eine Vorrichtung und ein Verfahren zum polyphasigen Resampling. Unter Resampling ist dabei insbesondere ein Neubestimmen von Stützstellen innerhalb eines zeitlichen Ablaufs, das heißt ein erneutes Abtasten einer Datenfolge unter Einsatz eines Interpolationsverfahrens zu verstehen.

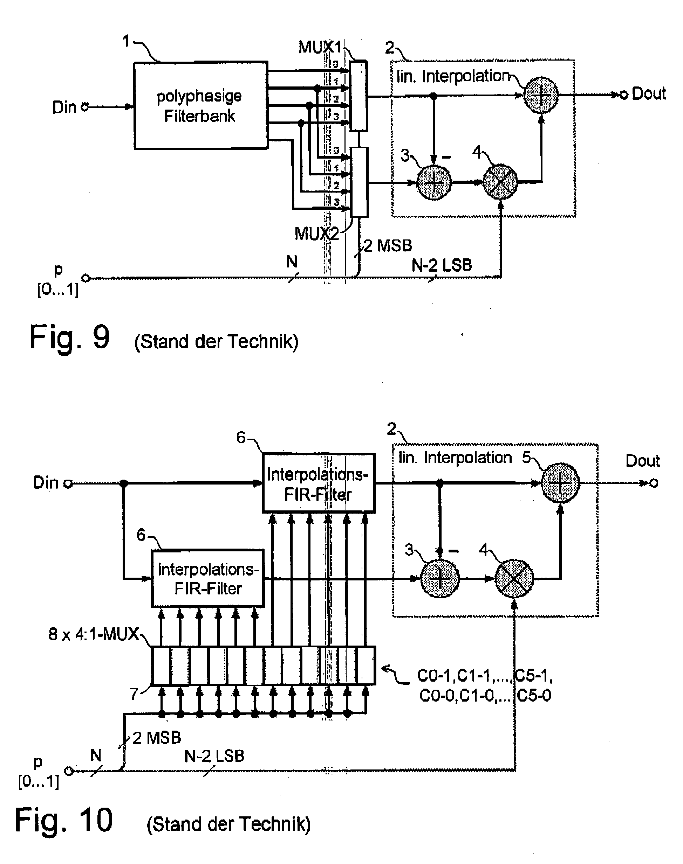

Zur Hardware-Umsetzung eines polyphasigen Resamplings sind zwei Lösungen bekannt. Die erste Lösung wird derzeit für eine Bildskalierung in Video-Verarbeitungschips verwendet. Wie dies aus Fig. 9 ersichtlich ist, wird an einer polyphasigen Filterbank 1 eine Abfolge von Eingangsdaten Din angelegt. Die polyphasige Filterbank 1 gibt bei dem dargestellten Beispiel fünf Ausgangswerte auf fünf Leitungen aus, wobei die ersten vier Leitungen an einem ersten Multiplexer MUX1 und die letzten vier dieser Leitungen an einem zweiten Multiplexer MUX2 angelegt sind. Außerdem wird ein Phasenwert p im Bereich von 0 bis 1 über einen Bus mit N-Leitungen an der Schaltung angelegt. Die beiden höchstwertigsten Bit (MSB / Most Significant Bit) werden einem Steuereingang der beiden Multiplexer MUX1, MUX2 angelegt. Die beiden Ausgangsleitungen der beiden Multiplexer MUX1, MUX2 und die N-2 niedrigstwertigen Bit (LSB / Least Significant Bit) des Phasenwerts p werden einer Interpolationsschaltung 2 angelegt. Die Interpolationsschaltung 2 weist einen ersten Addierer 3 auf, an dessen erstem Eingang ein Ausgang des zweiten Multiplexers MUX2 angelegt ist. An einem zweiten Eingang des ersten Addierers 3 wird der negative Betrag des vom ersten Multiplexer MUX1 über dessen Ausgang ausgegebenen Werts zum Durchführen einer Subtraktion angelegt. Ein Ausgangswert des ersten Addierers 3 wird mittels eines Multiplizierers 4 mit den N-2 niederwertigsten Bit des Phasenwerts p multipliziert. Das Multiplikationsergebnis des Multiplizierers 4 wird einem Eingang eines zweiten Addierers 5 angelegt, an dessen weiterem Additions-Eingang der Ausgangswert des ersten Multiplexers MUX1 angelegt ist. Eine Abfolge von Ausgangswerten des zweiten Addierers 5 wird einem Datenausgang als Ausgangsdaten Dout angelegt.

Mit einer solchen Schaltungsanordnung wird eine feste Anzahl von Ausgangswerten, gewöhnlich $2^K + 1$ mit gleich beabstandeten Unterabtastphasen (englisch: sub-sample phases) in dem Bereich [0...1) erzeugt. Abhängig von der gewünschten Phase wird ein Paar zueinander benachbarter Abtastwerte (engl.: samples) ausgewählt. Der Ausgangs-Abtastwert als ein Datenwert der Ausgangsdaten Dout wird durch eine lineare Interpolation zwischen diesen erhalten. Für K = 2 gibt es entsprechend dem dargestellten Ausführungsbeispiel fünf Ausgangswerte mit Phasen 0, 1/4, 2/4, 3/4, 1. Die erste Phase 0 als ein erster dieser Phasenwerte p entspricht dem momentanen Abtastwert der Eingangsdaten Din und die Phase 1 dem nächsten Abtastwert. Die dazwischen liegenden (engl.: intermediate) Phasen werden unter Verwendung einer hierarchischen baumartigen Struktur aus Filterbänken erzeugt. Dabei werden nur symmetrische Halbbandfilter mit konstanten Koeffizienten verwendet. Fig. 9 zeigt dabei eine Schaltungsanordnung für den Fall K = 2.

Gemäß der anhand Fig. 10 skizzierten zweiten Lösung werden zwei Interpolations-FIR-Filter (FIR: Finite Impulse Response / endliche Impulsantwort) mit variablen Koeffizienten verwendet. Der Ausgangs-Abtastwert wird durch eine lineare Interpolation zwischen zwei Filterausgangswerten bestimmt. Koeffizientensätze werden dabei für eine vordefinierte Anzahl äquidistanter Phasen, gewöhnlich $2^K + 1$ vordefiniert. Abhängig von der Ausgangsphase werden zwei benachbarte Koeffizienten unter Verwendung von Multiplexern ausgewählt und an die Interpolationsfilter angelegt. Fig. 10 zeigt wieder den Fall für K = 2.

Dabei werden die Eingangsdaten Din zwei Interpolations-FIR-Filtern 6 angelegt, wobei dem ersten der Interpolations-FIR-Filter 6 sechs erste Koeffizienten C0-1, C1-1, ..., C5-1 eines 8 x 4:1-Multiplexers 7 als Koeffizienten angelegt werden. Dem zweiten Interpolations-FIR-Filter 6 werden sechs weitere Filter-Koeffizienten C0-0, C1-0, ..., C5-0 angelegt. Den entsprechenden zwölf Eingängen des derart ausgebildeten Multiplexers 7 werden wieder die zwei höchstwertigen Bit (MSB) des Phasenwerts m angelegt, der an einem Bus mit N-Leitungen anliegt. Die Ausgangswerte der beiden Interpolations-FIR-Filter 6 werden, wie im Fall der Schaltungsanordnung gemäß Fig. 9, wieder einer Interpolationsschaltung 2 angelegt. Außerdem werden der Interpolationsschaltung 2 wieder entsprechend die N-2 niederwertigen Bit des Phasenwerts p angelegt.

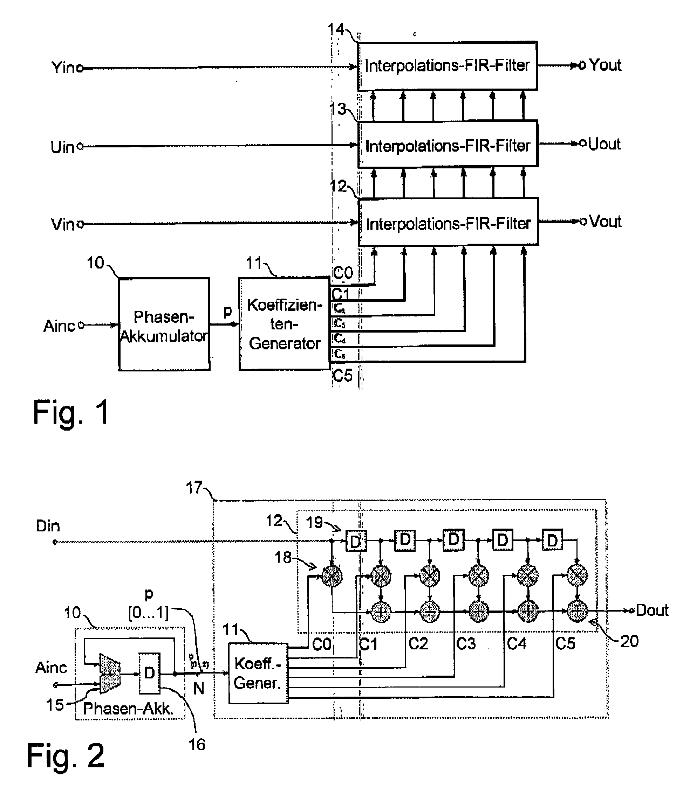

Jedoch weisen beide Schaltungsanordnungen Nachteile auf. Bei der ersten Lösung gemäß Fig. 1 werden nur zwei der $2^K + 1$-polyphasigen Ausgangswerte für eine gegebene Ausgangsphase verwendet, um eine lineare Interpolation durchzuführen. Die weiteren Ausgangswerte werden jedoch nicht verwendet. Trotzdem müssen alle Ausgangswerte erzeugt werden, um alle möglichen Phasenwerte p im Bereich [0 ... 1) handzuhaben. Eine Erhöhung der Anzahl polyphasiger Ausgangswerte, was eine Interpolations-Genauigkeit erhöhen würde, würde die Lösung noch ineffizienter machen. Nachteilhaft ist insbesondere auch, dass eine solche hierarchische Filterbank-Struktur für unterschiedliche Anzahlen von polyphasigen Ausgangswerten nicht leicht skaliert werden kann. Die zweite Lösung gemäß Fig. 10 hat den Nachteil, dass die Multiplizierer und Addierer der Interpolationsfilter dupliziert werden müssen. Ein gemeinsamer Nachteil beider Lösungen besteht dann, wenn mehrere Kanäle parallel zueinander interpoliert werden sollen, da eine lineare Interpolation für jeden Kanal individuell einzeln durchgeführt werden muss.

Die Aufgabe der Erfindung besteht darin, eine Vorrichtung und ein Verfahren zum polyphasigen Resampling vorzuschlagen, welche einen geringeren Aufwand bei gleichzeitig gleich guter oder besserer Genauigkeit ermöglichen.

Allgemein bekannt sind Anordnungen mit einem FIR-Filter als einem kontinuierlich variablen digitalen Verzögerungselement aus C.W.Farrow, Continuously Variable Digital Delay Element, AT&T, Middletown, New Jersey 07748, 1988 IEEE. Eine solche Architektur dient jedoch lediglich zur Berechnung von Koeffizienten für eine Lagrange-Polynom-Interpolation und wird auch als Farrow-Struktur bezeichnet.

Diese Aufgabe wird durch die Vorrichtung zum polyphasigen Resampling mit den Merkmalen gemäß Patentanspruch 1 bzw. durch das Verfahren zum polyphasigen Resampling mit den Merkmalen gemäß Patentanspruch 10 gelöst. Vorteilhafte Ausgestaltungen sind Gegenstand abhängiger Ansprüche.

Bevorzugt wird demgemäß eine Vorrichtung zum polyphasigen Resampling mit einem Koeffizienten-Generator zum Bereitstellen einer Vielzahl von Koeffizienten und einer Interpolationsanordnung zum Durchführen des Resamplings mittels der Koeffizienten auf Eingangsdaten zur Bereitstellung dem Resampling unterzogener Ausgangsdaten, wobei der Koeffizienten-Generator ausgebildet und/oder angesteuert ist zum Bereitstellen der Koeffizienten für das Resampling als linear interpolierte Koeffizienten.

Bevorzugt ist eine Vielzahl von zumindest zwei Daten-Interpolationsfiltern zum Interpolieren einer entsprechenden Anzahl von parallelen Eingangsdaten bereitgestellt, wobei die Koeffizienten jedem der Daten-Interpolationsfilter angelegt sind. Die Daten-Interpolationsfilter sind vorzugsweise als Interpolations-FIR-Filter ausgebildet.

Vorteilhaft ist dabei zumindest eine Interpolationsschaltung in dem Koeffizientengenerator zum Erzeugen der Koeffizienten aus konstanten Koeffizienten ausgebildet. Bevorzugt wird jedoch eine Vielzahl von zumindest zwei solcher Interpolationsschaltungen in dem Koeffizientengenerator zum Erzeugen der Koeffizienten aus konstanten Koeffizienten. Mittels einem Speicherabschnitt oder Dateneingang können die konstanten Koeffizienten dieser Anordnung auf einfache Art und Weise eingegeben werden.

Bevorzugt wird eine Vielzahl von zumindest zwei Interpolationsschaltungen in dem Koeffizientengenerator zum Erzeugen interner Koeffizienten und eine Normierungsschaltung zum Normieren der internen Koeffizienten zum Bereitstellen der für das Resampling zu verwendenden Koeffizienten.

Derartige Vorrichtungen sind bevorzugt ausgestaltet mit zumindest zwei Multiplexern zum Multiplexen einer ersten Koeffizientenfolge aus Koeffizienten auf zwei Eingänge jeweils einer der Interpolationsschaltungen und mit einem Phasen-Akkumulator zum Bereitstellen eines Phasenwerts aus einer Vielzahl von Bit, wobei höchstwertige Bit der Vielzahl von Bit den Multiplexern zu deren Ansteuerung und die niederwertigsten Bit der Vielzahl von Bit den Interpolationsschaltungen angelegt sind. Dabei sind bevorzugt eine Anzahl der höchstwertigen Bit entsprechend der Anzahl der Multiplexer den Multiplexern und die übrige Vielzahl der Vielzahl von Bit jeweils allen der Interpolationsschaltungen angelegt.

Verfahrensgemäß wird mit einem 'Koeffizienten-Generator zum polyphasigen Resampling eine Vielzahl von Koeffizienten bereitgestellt und das Resampling mittels der Koeffizienten auf Eingangsdaten zur Bereitstellung dem Resampling unterzogener Ausgangsdaten durchgeführt, wobei die Koeffizienten für das Resampling als linear interpolierte Koeffizienten bereitgestellt werden.

Dabei werden vorteilhaft die selben Koeffizienten jedem der Daten-Interpolationsfilter einer Vielzahl von zumindest zwei Daten-Interpolationsfiltern zum Interpolieren einer entsprechenden Anzahl von parallelen Eingangsdaten angelegt.

Verfahrensgemäß werden in dem Koeffizientengenerator Koeffizienten aus konstanten Koeffizienten erzeugt. In einem ersten bevorzugten Schritt werden dabei interne Koeffizienten erzeugt und zum Bereitstellen der für das Resampling zu verwendenden Koeffizienten normiert.

Ein zentraler Gedanke der Vorrichtung bzw. des Verfahrens besteht darin, dass eine Interpolation bzw. ein Resampling durch Filterung des Eingangssignals bzw. der Eingangsdaten mit einem FIR-Filter durchgeführt wird, dessen Koeffizienten von der Phase des interpolierten Abtastwerts relativ zu den Eingangs-Abtastwerten abhängen. Dazu werden die Koeffizienten des Interpolationsfilters unter Verwendung einer linearen Interpolation zwischen einer Anzahl vordefinierter Koeffizientensätze für äquidistante Unterabtastphasen (sub-sample phases) erzeugt. Für quantisierte Koeffizienten folgt die Interpolation durch eine Stufe, welche die Koeffizientennormierung zurückspeichert, welche durch den Interpolationsprozess bewirkt wird. Eine entsprechende Architektur einer Schaltungsanordnung ist insbesondere für eine mehrkanalige Interpolation effizient. Da alle Kanäle gleichzeitig neu abgetastet bzw. resampelt werden, kann der Koeffizienten-Erzeugungsblock zum Erzeugen der Koeffizienten gemeinsam (shared) verwendet werden. Lediglich der Interpolations-FIR-Filter ist für jeden Kanal zu replizieren.

Ein Ausführungsbeispiel wird nachfolgend anhand der Zeichnung näher erläutert. Dabei verweisen Komponenten und Funktionen bzw. Datenwerte mit zwischen den Figuren einheitlichen Bezugszeichen auf gleiche oder gleich wirkende Komponenten, Funktionen bzw. Datenwerte, so dass jeweils auf die ausführlichen Beschreibungen in anderen der Figuren mit detaillierteren Beschreibungen verwiesen werden kann.

Es zeigen:

Fig. 1    eine Interpolations-Architektur für eine Mehrkanal-Interpolation zur Veranschaulichung des Grundprinzips einer Vorrichtung bzw. einer Verfahrensweise zum polyphasigen Resampling,

Fig. 2    Komponenten einer eigentlichen Schaltungsanordnung bzw. Architektur zum Durchführen eines Resamplings,

Fig. 3    Diagramme zur Veranschaulichung einer Interpolations-filter-Polyphasen-Dekomposition,

Fig. 4    Diagramme zur Veranschaulichung einer linearen Interpolation zwischen gespeicherten Koeffizienten,

Fig. 5    schematisch einen Aufbau eines Koeffizienten-Generators,

Fig. 6    Komponenten einer Schaltungsanordnung für eine Koeffizienten-Neunormierung nach der Interpolation,

Fig. 7    eine Abbildung einer Original-Standard-Definitions-Zonenplatte,

Fig. 8    einen Ausschnitt eines Hoch-Definitions-Ergebnisses in vergrößerter Darstellung nach Skalierung,

Fig. 9    schematisch Komponenten einer Schaltungsanordnung zum Durchführen eines Resamplings gemäß einer ersten Lösung des Standes der Technik und

Fig. 10    schematisch eine Schaltungsanordnung gemäß einer zweiten Lösung des Standes der Technik.

Fig. 1 zeigt schematisch eine bevorzugte Vorrichtung zum polyphasigen Resampling. Drei verschiedene Eingangsanschlüsse zum Anlegen dreier verschiedener Folgen aus Eingangsdaten Yin, Uin, Vin sind an drei verschiedene Interpolations-FIR-Filter 12, 13, 14 angelegt. Außerdem liegen an jedem der Interpolations-FIR-Filter 12 - 14 Koeffizienten C0, C1, ..., C5 an. Eine Besonderheit dieser Ausführungsform besteht darin, dass jeder der Koeffizienten C0, C5 über eine eigene Leitung oder über durchgeschliffene Leitungen an jeden der Interpolations-FIR-Filter 12 -14 angelegt wird. Entsprechend arbeiten alle Interpolations-FIR-Filter 12 - 14 mit demselben Koeffizienten C0 - C5. Von den Interpolations-FIR-Filtern 12 - 14 werden jeweils Ausgangsdaten Yout, Uout, Vout an einem Ausgang bereitgestellt. Diese Ausgangsdaten Yout, Uout, Vout werden mit Hilfe der Koeffizienten C0 - C5 aus den Eingangsdaten Yin, Uin bzw. Vin erzeugt. Bei den Eingangsdaten bzw. Ausgangsdaten handelt es sich dabei um Daten beispielsweise eines Audiosignals mit bis zu fünf Kanälen und einem Videodatenstrom in beispielsweise den für sich bekannten Formaten RGB oder YUV.

Zur Erzeugung der Koeffizienten C0 - C5 wird ein Steuersignal Ainc an einem Eingang eines Phasen-Akkumulators 10 angelegt. Dieser akkumuliert die Daten des angelegten Steuersignals Ainc und stellt an seinem Ausgang einen Phasenwert p für einen Koeffizienten-Generator 11 bereit. Der Koeffizienten-Generator 11 erzeugt mit dem angelegten Phasenwert p die Koeffizienten C0 - C5.

Mittels einer solchen Schaltungsanordnung werden die über verschiedene Eingangsleitungen angelegten Eingangsdaten Yin, Uin, Vin entsprechend mit ein und demselben Satz von Koeffizienten C0 - C5, welche von dem Koeffizienten-Generator 11 entsprechend geeignet bereitgestellt werden, in jeweils einem eigenen Interpolations-FIR-Filter 12 - 14 gefiltert. Dabei sind sowohl unter den Eingangsdaten Yin, Uin, Vin als auch unter dem Steuersignal Ainc Daten bzw. Datenströme oder Signale zu verstehen, welche im Fall einer innerhalb einer übergeordneten Schaltung angeordneten Schaltungsanordnung als Eingangsdaten für diese spezielle Schaltungsanordnung und die darin beschriebenen Komponenten zu verstehen sind. Dies schließt jedoch nicht aus, dass diese Eingangsdaten Yin, Uin, Vin im Falle der Integration in einer übergeordneten Schaltungsanordnung auch von einer auch aus Sicht der übergeordneten Schaltungsanordnung externen Datenquelle stammen. Selbiges gilt auch für die Ausgangsdaten Yout, Uout, Vout, welche je nach Ausführungsform als Ausgangsdaten der speziell dargestellten Schaltungsanordnung oder auch als Ausgangsdaten einer übergeordneten Schaltung anzusehen sein können. Insbesondere muss eine vorteilhafte Schaltungsanordnung nicht drei zueinander parallele Kanäle mit drei Interpolations-FIR-Filtern 12- 14 aufweisen. Auch Schaltungsanordnungen mit weniger, insbesondere nur einem Interpolations-FIR-Filter 12, oder mit einer Vielzahl zusätzlicher Interpolations-FIR-Filter zum Filtern von Eingangsdaten weiterer Kanäle sind im Rahmen einer solchen Schaltungsanordnung implementierbar.

Eine solche Schaltungsanordnung bietet im Vergleich zu den beiden Schaltungsanordnungen gemäß Fig. 9 bzw. 10 eine Vielzahl von Vorteilen. So ist nur ein einziger generischer Interpolations-Filter für jeden Kanal erforderlich. Dieselben Koeffizienten werden für alle Kanäle verwendet. Ein weiterer Vorteil besteht darin, dass die Koeffizienten C0 - C5 nur von der gewünschten Ausgangsphase abhängig sind und daher mit einem gemeinsamen Block erzeugt werden können, der für alle Kanäle gemeinsam verwendet wird. Eine solche Lösung ist vorteilhafterweise sehr effizient und skalierbar für so viele Kanäle, wie dies erforderlich ist. Pro weiterem Kanal muss jeweils nur ein einziger zusätzlicher Interpolations-Filter ergänzt werden.

Diese Vielzahl von Vorteilen ermöglicht die Erkenntnis, dass eine Kombination der verschiedenen Aspekte der beiden für sich bekannten Lösungen aufgrund der Linearitäts-Voraussetzungen ermöglicht wird.

Der zentrale Block der Schaltungsanordnung wird durch den Koeffizienten-Generator 11 ausgebildet. Anstatt eine lineare Interpolation an dem Ausgang der Interpolations-Filter durchzuführen, wird die Interpolation auf die Koeffizienten C0 - C5 angewendet. Da eine Interpolation eine lineare Operation ist, ist die Verlagerung des Interpolationsvorgangs vom Filterausgang auf die Koeffizienten ohne Auswirkung auf das Endergebnis, was aus Gleichung 1 erkennbar ist. Es gilt

$$Y\text{int} = \text{Int}(Y_0, Y_1) = \text{Int}\left(\sum_k C_{0k} X_k, \sum_k C_{1k} X_k\right) = \sum_k \text{Int}(C_{0k} C_{1k}) X_k \qquad (1)$$

mit $X_k$ als den originären bzw. ursprünglichen Abtastwerten in den Filterabgriffen, $C_{0k}$ und $C_{1k}$ als den Koeffizientensätzen für die beiden Filter, $Y_0$ und $Y_1$ als den Ausgangsdaten der Filter und $Y_{int}$ als den Ausgangsdaten nach der linearen Interpolation.

Ein Vorteil der vorgeschlagenen Interpolations-Architektur ist insbesondere im Fall von Mehrkanalanwendungen erkennbar, wie dies anhand von Fig. 1 skizziert ist. Bei solchen beispielhaften Anwendungen werden Daten auf mehr als einem Datenkanal gleichzeitig resampelt. Mögliche Beispiele für entsprechende Mehrkanalsignale umfassen beispielsweise,komplexe Signale in Kommunikationsverbindungen, Audiosignale bis insbesondere zu fünf Kanälen und Bilddatenströme gemäß beispielsweise RGB oder YUV. Sowohl der Phasen-Akkumulator 10 als auch der Koeffizienten-Generator 11 können vorteilhaft gemeinsam verwendet werden, um gemeinsam jeweils nur einen Interpolations-FIR-Filter 12 - 14 pro Datenkanal anzusteuern, um beispielsweise einen YUV-Bilddatenstrom neu abzutasten.

Fig. 2 zeigt eine beispielhafte Schaltungsanordnung einer Resampler-Architektur mit einer detaillierteren Darstellung des Phasen-Akkumulators 10 und eines einzelnen Interpolations-FIR-Filters 12. Lediglich beispielhaft sind dabei der Interpolations-FIR-Filter 12 und der Koeffizienten-Generator 11 in einer gemeinsamen übergeordneten Baueinheit aufgenommen, welche den eigentlichen Resampler als einem variablen Verzögerungselement in der Grundstufe für einen einzelnen Kanal mit Eingangsdaten Din ausbildet.

Der Phasen-Akkumulator 10 weist einen Addierer und/oder Verstärker 15 auf, dessen Ausgangswert einem Verzögerungselement 16, D anliegt. Ein Ausgang des Verzögerungselements 16 wird an einen zweiten Eingang des Addierers und/oder Verstärkers 15 zurückgeführt und mit dem am ersten Eingang anliegenden Steuersignal Ainc bzw. dessen Datenwerten gemeinsam verarbeitet. Außerdem wird der Ausgang des Verzögexungselements 16 wie in Fig. 1 an einen Eingang des Koeffizienten-Generators 11 geschaltet. Ausgegeben werden vom Phasen-Akkumulator einzelne Phasenwerte p in einem Bereich [0 ... 1) auf einer Leitungsanordnung mit N einzelnen Leitern.

In dem beispielhaften Interpolations-FIR-Filter 12 ist eine Vielzahl von Multiplizierern 18, von Verzögerungselementen 19, D und von Addierern 20 angeordnet. Die Eingangsdaten Din werden dabei an die in Reihe geschalteten Verzögerungselemente 19 angelegt und von Glied zu Glied der Verzögerungselemente 19 entsprechend verzögert. Die Eingangsdaten Din werden außerdem einem ersten der Multiplizierer 18 zur Multiplikation mit dem ersten der Koeffizienten C0 angelegt. Den weiteren der Multiplizierern 18 wird jeweils der Ausgangswert eines der Verzögerungselemente 19 sowie als weiterer zu multiplizierender Eingangswert ein weiterer der Koeffizienten C1 - C5 angelegt. Entsprechend multiplizieren die Multiplizierer 18 jeweils einen der Koeffizienten C0 - C5 mit einem Datenwert der Eingangsdaten Din bzw. dazu vorherigen Datenwerten einer Folge der Eingangsdaten Din. Der letzte der Addierer 20 gibt die Ausgangsdaten Dout nacheinander aus.

Ein Grundaufbau besteht entsprechend aus dem Phasen-Akkumulator 10, dem Koeffizienten-Generator 11 und einem oder mehreren solcher Interpolations-Filter, insbesondere Interpolations-FIR-Filter 12. Dabei bilden der Koeffizienten-Generator 11 und der oder die Interpolations-Filter 12 - 14 einen Unterabtast- bzw. Sub-Sample-Interpolator aus. Bei einer Umsetzung in den Bereich von Kommunikationsverbindungen, wird eine derartige Struktur für sich genommen als variables Verzögerungselement bezeichnet. Vorliegend können jedoch nicht nur Koeffizienten für eine Lagrange-Polynom-Interpolation berechnet werden, wie bei der so genannten Farrow-Struktur. Die anhand der Fig. 1 und 2 vorgeschlagene Schaltungsanordnungs-Architektur bietet im Gegensatz zur Farrow-Struktur eine geringere Komplexität und ist allgemeiner gehalten, so dass sie für beliebige Interpolationsfunktionen und nicht nur eine Lagrange-Polynom-Interpolation anwendbar ist. Dadurch wird die Erzeugung einer beliebigen Ausgangsphase zur Bereitstellung des bzw. der gewünschten Phasenwerte p unter Verwendung einer relativ geringen Anzahl gespeicherter Koeffizientensätze ermöglicht.

Ein weiterer vorteilhafter Aspekt der bevorzugten Vorrichtung und bevorzugten Verfahrensweise besteht darin, Koeffizienten für eine vorzugsweise begrenzte Anzahl äquidistanter Phasenwerte p zu speichern, wobei für die Anzahl eine Potenz von 2 bevorzugt wird.

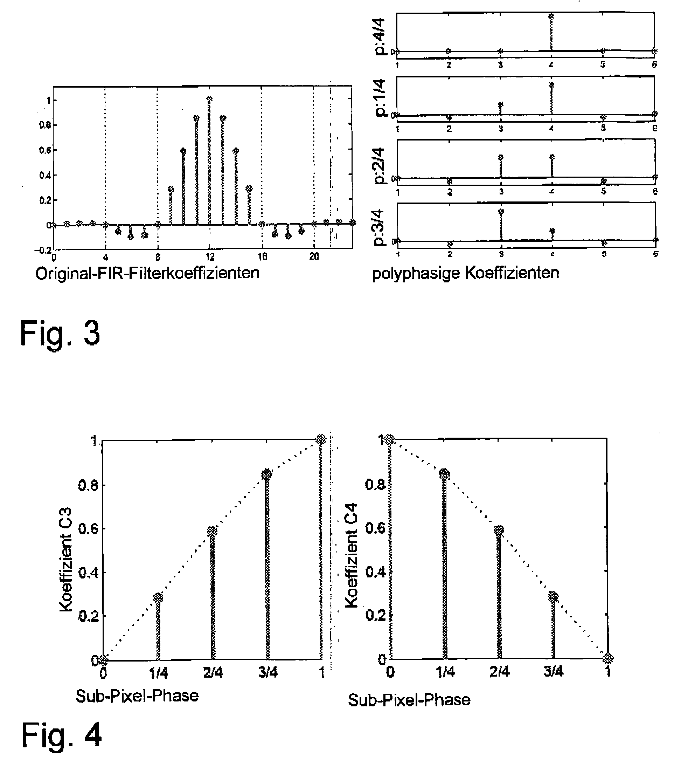

Für einen gegebenen Phasenwert p werden die aktuellen FilterKoeffizienten C0 - C5 durch eine polyphasige Dekomposition bzw. Zerlegung einer ursprünglichen Interpolationsfunktion erhalten. Dies ist beispielhaft anhand Fig. 3 für einen sechswertigen Interpolationsfilter mit vier Phasenwerten bzw. einem Interpolationsfilter mit sechs Abgriffen (Taps) beschrieben. Dabei ist auf der rechten Seite ein Diagramm ursprünglicher FIR-Filterkoeffizienten mit 24 Abtastwerten und einem symmetrischen Aufbau um den mittleren Abtastwert, welcher auf den Wert 1 normiert ist, dargestellt. In der rechten Abbildung von Fig. 3 sind dem entsprechend vier beispielhafte polyphasige Koeffizienten mit nur jeweils sechs Koeffizientenwerten dargestellt, welche beispielsweise den Koeffizienten C0 - C5 gemäß Fig. 1 und 2 entsprechen können. Die vier Abbildungen auf der rechten Seite von Fig. 3 zeigen dabei entsprechende polyphasige Koeffizientensätze für Phasenwerte p = 3/4, 2/4, 1/4, 0/4.

Fig. 4 veranschaulicht den Interpolationsprozess für die beiden zentralen Abgriffe bzw. Abtastwerte eines solchen Filters mit sechs Abgriffen. Die Anzahl der Koeffizientensätze für P Phasenwerte p ist dabei P+1, da die Koeffizienten für eine erste Phase 1 für eine lineare Interpolation benötigt werden. Diese Koeffizienten für die Phase 1 sind dabei einfach die Koeffizienten für die Phase 0 in umgekehrter Reihenfolge. Im Fall von vier Polyphasen werden fünf Koeffizientensätze gespeichert, jeweils einer für die Phasenwerte p = 0, 1/4, 2/4, 3/4, 1.

Das Abtastintervall wird so in P Segmente mit gleichen Abständen bzw. Breiten aufgeteilt. Um eine lineare Interpolation durchzuführen, sind eine Segmentanzahl $K_s$ und eine Intra-Segmentphase $\Phi_s$ zu berechnen gemäß

$$K_s = \lfloor P * \Phi_0 \rfloor, \quad K_s \in \{0, 1, \ldots, P-1\} \text{ und} \tag{2}$$

$$\Phi_s = P \cdot \Phi_0 - K_s, \quad \Phi_s \in [0 \ldots 1). \tag{3}$$

Die gewünschte Ausgangsphase im Bereich [0...1) ist dabei als $\Phi_0$ bezeichnet. Der interne Ausgangs-Koeffizient Cint wird durch die lineare Interpolation zwischen den ausgewählten benachbarten Koeffizienten $C_{ks}$ und $C_{Ks+1}$ berechnet gemäß

$$C_{int} = C_{Ks} + \Phi_s (C_{Ks+1} - C_{Ks}). \tag{4}$$

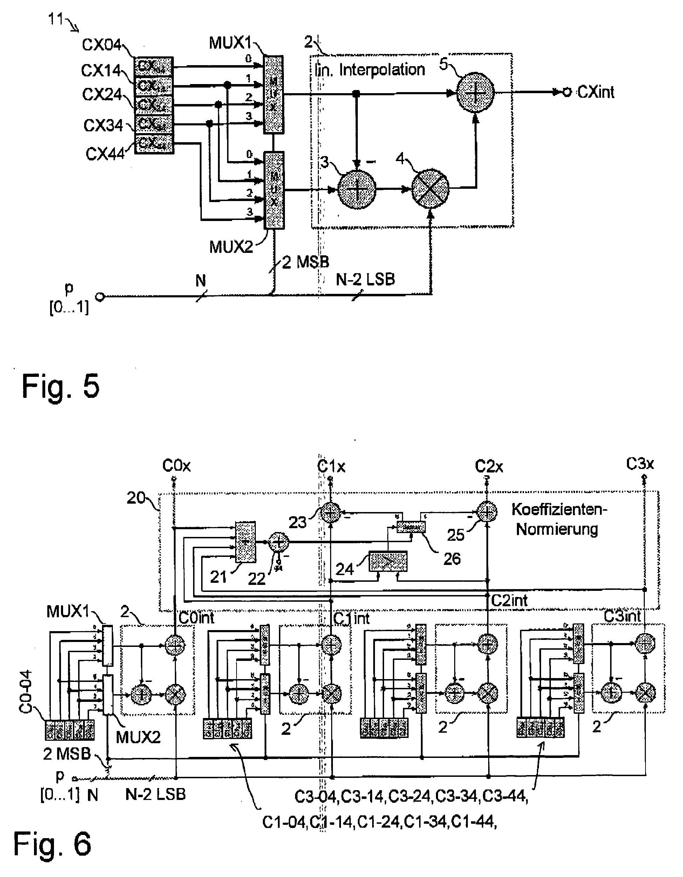

In eine Hardwarestruktur umgesetzt wird die Phase $\phi_0$ unter Verwendung einer festen Anzahl von N Bit codiert. Falls die Anzahl der Koeffizientensätze eine Potenz von 2 ist, beispielsweise $2^Q$, kann die Auswahl der beiden benachbarten Koeffizienten mit zwei Multiplexern MUX1, MUX2 durchgeführt werden, welche durch die ersten Q Bit, das heißt die ersten Q MSB des N-Bit-Phasenworts des angelegten Phasenwerts p gebildet werden. Dies ist schematisch für einen Koeffizienten-Generator 11 anhand Fig. 5 veranschaulicht. Dabei werden entsprechend der Darstellung den z. B. jeweils vier Eingängen 0 - 3 der beiden Multiplexer MUX1, MUX2 konstante Koeffizienten CX04, CX14, CX24, CX34 bzw. CX44 angelegt. Den Eingängen des ersten der beiden Multiplexer MUX1 werden die ersten vier dieser Koeffizienten und den Eingängen des zweiten der Multiplexer MUX2 die letzten vier dieser Koeffizienten angelegt. Die Ausgangswerte der beiden Multiplexer MUX1, MUX2 werden beispielsweise einer Interpolationsschaltung 2 gemäß dem Aufbau entsprechend Fig. 9 angelegt. Ausgegeben wird von dieser Interpolationsschaltung 2 entsprechend eine Abfolge von Ausgangsdaten in Form interner Koeffizienten CXint.

Die verbleibenden N-Q Bit des Phäsenwerts p repräsentieren die Intra-Segmentphase $\phi_s$ und werden direkt für die Interpolation verwendet, das heißt dem Multiplizier 4 der Interpolationsschaltung 2 zur Multiplikation mit dem Ausgangswert des ersten Addierers 3 der Interpolationsschaltung 2 angelegt. Das Multiplikationsergebnis des Multiplizierers 4 wird dem zweiten Addierer 5 der Interpolationsschaltung 2 angelegt, dem die Ausgangsdaten des ersten Multiplexers MUX1 anliegen und welcher die interner Koeffizienten CXint ausgibt. Dem ersten Addierer 3 der Interpolationsschaltung 2 liegen Ausgangswerte des zweiten Multiplexers MUX2 und zur Subtraktion davon Ausgangswerte des ersten Multiplexers MUX1 an.

In den meisten derzeit betrachtbaren Anwendungen werden die Koeffizienten für jede Phase normiert, das heißt deren Summe ist 1. Dies stellt sicher, dass die Antwort bei einem Wechselstrom für alle Phasen gleich ist. Falls diese Bedingung nicht erfüllt wird, können Rippel (deutsch: Welligkeit) für langsam variierende Signale auftreten, welche sich als unerwünschte hochfrequente Komponenten in dem Spektrum des interpolierten Signals zeigen.

Wenn die Koeffizienten eine endliche Genauigkeit aufweisen, kann der lineare Interpolationsprozess die Normierung der Koeffizienten beeinflussen. Simulationen zeigen, dass für diskretisierte Koeffizienten mit der Summe für jede Phase gleich 256 die resultierende Summe nach der linearen Interpolation mit einem Wert +/- 2 um den durchschnittlichen Wert 256 variieren kann. Gemäß einer bevorzugten Ausgestaltung der vorteilhaften Schaltungsanordnung werden die Koeffizienten zur Vermeidung oder Reduzierung eines solchen Einflusses nach der linearen Interpolation neu normiert. Eine solche neue Normierung wird durch Berechnung des Fehlers der Koeffizientensumme und dessen Subtraktion von dem Wert des größten der beiden zentralen Abgriffswerte bzw. Koeffizientenwerte durchgeführt. Ein Schema für einen solchen Ansatz ist anhand eines beispielhaften Vier-Abgriffs-Interpoolationsfilers anhand Fig. 6 beispielhaft veranschaulicht.

Fig. 6 zeigt beispielhaft eine Anordnung, bei welcher der Phasenwert p einer Vielzahl individueller Schaltungsanordnungen gemäß Fig. 5 angelegt wird. Jeder der individuellen Schaltungsanordnungen liegt außerdem jeweils ein Satz konstanter Koeffizienten an. Beispielsweise sind die Koeffizienten der zweiten dieser Unteranordnungen mit C1-04, C1-14, C1-24, C1-34, C1-44 nummeriert, während die letzte der vier beispielhaften Untergruppen der Schaltungsanordnung Koeffizienten C3-04, C3-14, C3-24, C3-34, C3-44 aufweist. Jede dieser Schaltungsanordnungen gibt einen entsprechenden Datenausgangswert als einen internen Koeffizienten C0int, C1int, C2int bzw. C3int aus, welche einer Normierungsschaltung 20 angelegt werden. Der erste und der letzte dieser internen Koeffizienten C0int, C3int werden als nullter bzw. dritter Koeffizient C0x, C3x unverändert von der Normierungsschaltung 20 ausgegeben. In der Normierungsschaltung 20 werden alle vier internen Koeffizienten C0int - C3int der vorgeschalteten Interpolationsschaltungen 2 einem Addierer 21 der Normierungsschaltung 20 zugeführt und in diesem aufaddiert. Von dem Additionsergebnis dieses Addierers 21 wird in einem nachfolgenden Addierer 22 ein konstanter Wert abgezogen, beispielsweise wie dargestellt der Wert 64 als Gesamtwert der Anzahl der konstanten Koeffizienten C0-04, ..., C3-44. Das Ausgangsergebnis dieses weiteren Addierers 22 wird einem Demultiplexer 26 angelegt, dem außerdem ein Ausgangssignal einer Größer/ Kleiner-Vergleichsschaltung 24 anliegt. Dieser Vergleichsschaltung 24 liegen die Ausgangswerte der beiden vorgeschalteten Interpolationsschaltungen 2 der beiden mittleren Koeffizienten-Bestimmungsstufen an. Diese internen Koeffizienten C1int, C2int liegen außerdem an noch weiteren Addierern 23, 25 an, in denen vom Demultiplexer 26 zur Subtraktion jeweils entsprechend der Wert 0 oder 1 abhängig vom Ergebnis des Demultiplexing-Vorgangs angelegt wird. Diese beiden weiteren Addierer 23, 25 geben dann die für die eigentliche Interpolation zu verwendenden normierten mittleren Koeffizienten C1x, C2x aus.

Umsetzbar sind mit einer derartigen Schaltungsanordnung besonders vorteilhaft Bildskalierungen in Videoanwendungen, beispielsweise eine Skalierung von einer Standard-Definition zu der so genannten High-Definition. Weitere Einsatzbereiche sind beispielsweise eine Audio-Abtastratenwandlung, der Einsatz als variables Sub-Sample-Verzögerungselement in digitalen Empfangsgeräten oder die Erzeugung von so genannten Doppler-Ausblendabgriffen (Doppler-Fading-Taps) in zeitlich variierenden Mehrwege-Kommunikationskanälen.

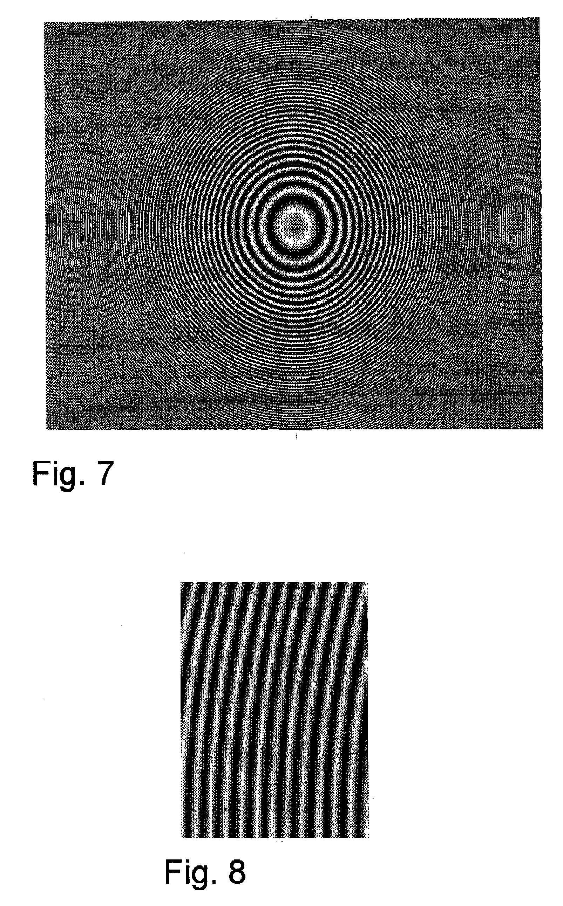

Erste Simulationen wurden versuchsweise für eine Bildskalierung durchgeführt. Als typischer Testfall wurde ein Bild gemäß Standarddefinition (720 x 576 Bildpunkte) für eine Anzeige gemäß High-Definition (1920 x 1080 Bildpunkte) skaliert. Eine Standarddefinitions-Zonenplatte dafür ist anhand Fig. 7 skizziert. Ein linksseitiger Randbereichsausschnitt des Skalierungsergebnisses gemäß High-Definition ist in Fig. 8 mit einer dreifachen Vergrößerung anhand eines 90 x 120-Bildpunkteausschnitts dargestellt. Für die Skalierung wurde als lineare Interpolation eine, 8-Tap-Lanczos-Interpolation mit acht Koeffizientensätzen in sowohl horizontaler als auch vertikaler Richtung durchgeführt.

## Patentansprüche

1. Vorrichtung zum polyphasigen Resampling mit

   - einem Koeffizienten-Generator (11) zum Bereitstellen einer Vielzahl von Koeffizienten (C0, C1, ..., C5) und
   - einer Interpolationsanordnung zum Durchführen des Resamplings mittels der Koeffizienten (C0 - C5) auf Eingangsdaten (Din; Yin, Uin, Vin) zur Bereitstellung dem Resampling unterzogener Ausgangsdaten (Dout; Yout, Uout, Vout),

   **dadurch gekennzeichnet, dass**

   - der Koeffizienten-Generator (11) ausgebildet und/oder angesteuert ist zum Bereitstellen der Koeffizienten (C0 - C5) für das Resampling als linear interpolierte Koeffizienten.

2. Vorrichtung nach Anspruch 1, bei der eine Vielzahl von zumindest zwei Daten-Interpolationsfiltern (12, 13, 14) zum Interpolieren einer entsprechenden Anzahl von parallelen Eingangsdaten (Yin, Uin, Vin) bereitgestellt ist, wobei die Koeffizienten (C0 - C5) jedem der Daten-Interpolationsfilter angelegt sind.

3. Vorrichtung nach Anspruch 2, bei der die Daten-Interpolationsfilter als Interpolations-FIR-Filter (12 - 14) ausgebildet sind.

4. Vorrichtung nach einem vorstehenden Anspruch mit zumindest einer Interpolationsschaltung (2) in dem Koeffizientengenerator (11) zum Erzeugen der Koeffizienten (C0 - C5; C0x, C1x, C2x, C3x) aus konstanten Koeffizienten (C0-04, ..., C3-44).

5. Vorrichtung nach Anspruch 4 mit einer Vielzahl von zumindest zwei solcher Interpolationsschaltungen (2) in dem Koeffizientengenerator (11) zum Erzeugen der Koeffizienten (C0 - C5; C0x, C1x, C2x, C3x) aus konstanten Koeffizienten (CX04 - CX44; C0-04, ..., C3-44).

6. Vorrichtung nach einem der Ansprüche 4 oder 5 mit einem Speicherabschnitt oder Dateneingang zum Eingeben der konstanten Koeffizienten (CX04 - CX44; C0-04, ..., C3-44).

7. Vorrichtung nach einem vorstehenden Anspruch mit

   - einer Vielzahl von zumindest zwei Interpolationsschaltungen (2) in dem Koeffizientengenerator (11) zum Erzeugen interner Koeffizienten (C0int, C1int, C2int, C3int) und
   - einer Normierungsschaltung (20) zum Normieren der internen Koeffizienten (C0int, C1int, C2int, C3int) zum Bereitstellen der für das Resampling zu verwendenden Koeffizienten (C0 - C5; C0x, C1x, C2x, C3x).

8. Vorrichtung nach einem der Ansprüche 4 bis 7 mit

   - zumindest zwei Multiplexern (MUX1, MUX2) zum Multiplexen einer ersten Koeffizientenfolge aus Koeffizienten (CX04 - CX44; C0-04, ..., C3-44) auf zwei Eingänge jeweils einer der Interpolationsschaltungen (2) und
   - einem Phasen-Akkumulator (10) zum Bereitstellen eines Phasenwerts (p) aus einer Vielzahl (N) von Bit,
   - wobei höchstwertige Bit (N, N-1) der Vielzahl (N) von Bit den Multiplexern (MUX1, MUX2) zu deren Ansteuerung und die niederwertigsten Bit der Vielzahl (N) von Bit den Interpolationsschaltungen (2) angelegt sind.

9. Vorrichtung nach Anspruch 8, bei der eine Anzahl der höchstwertigen Bit (N, N-1) entsprechend der Anzahl der Multiplexer (MUX1, MUX2) den Multiplexern (MUX1, MUX2) und die übrige Vielzahl (N-2) der Vielzahl (N) von Bit jeweils allen der Interpolationsschaltungen (2) angelegt sind.

10. Verfahren zum polyphasigen Resampling, bei dem eine Vielzahl von Koeffizienten (C0, C1, ..., C5) mit einem Koeffizienten-Generator (11) bereitgestellt wird und das Resampling mittels der Koeffizienten (C0 - C5) auf Eingangsdaten (Din; Yin, Uin, Vin) zur Bereitstellung dem Resampling unterzogener Ausgangsdaten (Dout; Yout, Uout, Vout) durchgeführt wird,
    **dadurch gekennzeichnet, dass**
    die Koeffizienten (C0 - C5) für das Resampling als linear interpolierte Koeffizienten bereitgestellt werden.

11. Verfahren nach Anspruch 10, bei dem die selben Koeffizienten (C0 - C5) jedem der Daten-Interpolationsfilter einer Vielzahl von zumindest zwei Daten-Interpolationsfiltern (12, 13, 14) zum Interpolieren einer entsprechenden Anzahl von parallelen Eingangsdaten (Yin, Uin, Vin) angelegt werden.

12. Verfahren nach Anspruch 10 oder 11, bei dem in dem Koeffizientengenerator (11) Koeffizienten (C0 - C5; C0x, C1x, C2x, C3x) aus konstanten Koeffizienten (C0-04, ..., C3-44) erzeugt werden.

13. Verfahren nach einem der Ansprüche 10 bis 12, bei dem interne Koeffizienten erzeugt und zum Bereitstellen der für das Resampling zu verwendenden Koeffizienten normiert werden.

14. Vorrichtung nach einem der Ansprüche 1 bis 9 zum Durchführen eines Verfahrens nach einem der Ansprüche 10 bis 13.

**Fig. 1**

**Fig. 2**

Original-FIR-Filterkoeffizienten     polyphasige Koeffizienten

# Fig. 3

Sub-Pixel-Phase     Sub-Pixel-Phase

# Fig. 4

Fig. 5

Fig. 6

Fig. 7

Fig. 8

Fig. 9 (Stand der Technik)

Fig. 10 (Stand der Technik)

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- Continously Variable Digital Delay Element. **C.W.FARROW.** AT&T. IEEE, 1988